(19) Europäisches Patentamt
European Patent Office
Office européen des brevets

(11) **EP 1 158 585 A1**

## (12) EUROPEAN PATENT APPLICATION
published in accordance with Art. 158(3) EPC

(43) Date of publication:
**28.11.2001 Bulletin 2001/48**

(21) Application number: **99954546.0**

(22) Date of filing: **27.07.1999**

(51) Int Cl.7: **H01L 33/00**

(86) International application number:
**PCT/RU99/00245**

(87) International publication number:
**WO 00/39860 (06.07.2000 Gazette 2000/27)**

(84) Designated Contracting States:
**AT BE CH CY DE DK ES FI FR GB GR IE IT LI LU MC NL PT SE**
Designated Extension States:
**AL LT LV MK RO SI**

(30) Priority: **29.12.1998 RU 98123248**

(71) Applicant: **Shveikin, Vasily Ivanovich
Moscow, 117393 (RU)**

(72) Inventor: **Shveikin, Vasily Ivanovich
Moscow, 117393 (RU)**

(74) Representative: **Winkler, Andreas, Dr.
FORRESTER & BOEHMERT
Pettenkoferstrasse 20-22
80336 München (DE)**

## (54) INJECTION NON-COHERENT EMITTER

(57) The present invention relates to an injection non-coherent emitter that ensures the output of a directed, spontaneous and outflowing radiation at reduced divergence angles with increased external efficiency as well as with increased energetic and luminous power. This emitter includes, in the whole heterostructure (2), a plurality of layers and sublayers having compositions and thicknesses that lay within predetermined ranges, and also includes a plurality of layers for the radiation output area (7). This invention also relates to different modifications in the heterostructure and the output area which allow for the output of the radiation in different controlled directions, including in a direction perpendicular to the active layers of said emitters. This invention further relates to multiple-beam non-cherent emitters, including radiating rulers and matrices having autonomously controlled beams.

FIG.1

**Description**

Field of the Invention

The invention relates to optoelectronics technology, and specifically to efficient, high-power, superluminescent and compact semiconductor diode spontaneous emission sources with a narrow radiation pattern.

Prior Art

An injection incoherent emitter (hereinafter referred to as "Emitter") is a device that converts electrical energy to optical radiation energy of a specified spectral composition and spatial distribution (in the absence of an optical resonator). Various types of injection incoherent emitters are known for a broad range of wavelengths, from infrared to blue and ultraviolet radiation: surface-emitting light-emitting diodes, including luminescent multipass light-emitting diodes [F.A. Kish et al., Appl. Phys. Lett., v.64, No. 20, pp. 2839-2841 (1994); H. Sugawara et al., Jap. J. Appl. Phys., v.31, No.8, pp. 2446-2451 (1992); 3 M. Watanabe, et al., US Patent, No. 5,537,433, July 16, 1996; S. Nakamura et al., Jap. J. Appl. Phys. Lett., v.34, L1332, (1995)] and edge emitters [A.T. Semenov et al., Electron. Lett., v.29, pp. 854-857, (1993); G.A. Alphonse et al., IEEE J. of Quant. Electronics, v.QE-24, pp.2454-2457, (1988)]. Further broad application of these radiation sources has been impeded by insufficiently high efficiency, radiation intensity and power and also, for a number of applications, by the large divergence of the radiation.

The known Emitter from [F.A. Kish et al., Appl. Phys. Lett., v.64, No.20, pp. 2839-2841 (1994)] is multipass and includes a heterostructure based on the semiconductor compounds AlGaInP, containing an active layer with band-gap $E_a$ (eV), thickness $d_a$ within the range 1 μm to 1.5 μm and two cladding layers (*p*-type and n-type conductivity) of optically homogeneous layers consisting of a single sublayer and disposed respectively on the first and opposite second surfaces of the active layer. The inner surfaces of area $S_{in}$ μm$^2$ of two radiation output regions are placed, one on each side, on the surfaces of the cladding layers that are remote from the active layer; said radiation output regions (hereinafter referred to as ROR) are made from the homogeneous semiconductor compound GaP, that is transparent to the radiation and of *p*-type and n-type conductivity, in the shape of rectangular parallelepipeds. The lateral surfaces of the parallelepipeds make linear angles of inclination $\psi$ of 90° with the inner and outer surfaces, and also with the plane of the active layer. The charge carrier injection region, of area SIR (μm$^2$), coincides with the active layer and is formed by ohmic contacts made respectively to the p-type and n-type radiation output regions. The required corresponding metallization layers are present. When a d.c. current is applied, recombination of nonequilibrium carriers occurs in the injection region with generation of spontaneous emission, propagating in all directions from the injection region, including toward both p-type and n-type output regions. After random multiple reflections, a certain fraction of the spontaneous emission exits at various angles from the light-emitting diode through the output surfaces. The latter are partially located on the outer surface of the p-type output region and the lateral surfaces of the output regions of both types. The angle of divergence $\theta_1$ of the output radiation in the vertical planes and the angle of divergence $\theta_2$ of the output radiation in the horizontal planes have the maximum permissible values (up to 180°) in this case. Here and in the following, we define the vertical planes as the planes perpendicular to the plane of the active layer. We define the horizontal planes as the planes that are perpendicular to the vertical planes and located on the output surfaces. Note that to each direction of the radiation passing through the horizontal plane may correspond its own vertical plane, containing radiation beams of the aforementioned direction. For a wavelength of 604 nm, the known Emitter [F.A. Kish et al., Appl. Phys. Lett., v.64, No.20, pp.2839-2841, (1994)] has external efficiency 11.5% and optical power of the radiation (for a current of 1 A) 93.2 lm/A. Its operating current density for continuous wave (cw) operation is no higher than 100 A/cm$^2$. In this case, the direction of the light beams relative to the output surfaces is chaotic (random).

Disclosure of the invention

The problem addressed by the invention is to design an Emitter with increased external efficiency, power, optical power, radiation intensity, and optical radiation intensity, with the ability to realize directional spontaneous emission with a broad range of directions for its output, including design of multibeam Emitters, linear and two-dimensional emitter arrays, including those with beams that may be independently switched on, while simplifying the technology for making them.

According to the invention, the problem addressed is solved by proposing an injection incoherent emitter, comprising a heterostructure containing an active layer, cladding layers, ohmic contacts, and at least on one side of the active layer, adjacent to the corresponding cladding layer, a radiation output region that is transparent to the radiation; and at least one radiation output region is made and said output region has at least one layer characterized by refractive index $n_{RORq}$, optical loss factor for the radiation $\alpha_{RORq}$ (cm$^{-1}$), thickness $d_{RORq}$ (μm), where $q = 1, 2,..., p$ are defined as integers that designate the sequential numbers labeling the layers of the output region, as counted from its boundary with the heterostructure; and the heterostructure with the adjoining radiation output region is characterized by an effective refractive index $n_{eff}$, where the effective refractive index $n_{eff}$ and the refractive index $n_{ROR1}$ are selected to satisfy the relations:

$$\text{arccos}(n_{eff}/n_{ROR1}) \le \text{arccos } (n_{eff\text{-}min}/n_{ROR1}), \text{ and } n_{eff\text{-}min} \text{ is greater than } n_{min},$$

where $n_{eff\text{-}min}$ is the minimum value of $n_{eff}$ of all possible $n_{eff}$ for the multitude of laser heterostructures with radiation output regions that are of practical value, and $n_{min}$ is the smallest of the refractive indices in the cladding layers of the heterostructure.

A distinction of the proposed Emitters is the essential features of the entire heterostructure and the radiation output region, which affect the details of their operation and the output characteristics achieved for the Emitters. The number of layers and sublayers of the heterostructure, their thicknesses and composition are selected for the proposed Emitter to achieve a narrow radiation pattern, especially in the vertical planes, for intense spontaneous emission appearing in the injection region and predominantly directed at propagation angles $\varphi$ relative to the plane of the active layer. The necessary condition for this is that the relation known as the leakage condition for laser modes propagated in the optical resonator of laser diodes [J.K. Buttler, Y. Kressel and I. Ladany, IEEE Journ. Quant. Electron., v.QE-11, p.402, (1975)] be satisfied:

$$n_{eff} < n_{ROR1} \tag{1}$$

The effective refractive index $n_{eff}$ can be obtained by computation from the relation ($\beta = (2\pi/\lambda)n_{eff}$, where $\beta$ is the absolute value of the complex wave propagation constant for the radiation in one of the directions in active layer 3, and $\lambda$ is the radiation wavelength. In the present invention, we have proposed and experimentally confirmed that condition (1) is also applicable to spontaneous emission. Accordingly, the propagation angle $\varphi$ for directional spontaneous emission is defined as equal to the leakage angle for the laser modes, and specifically

$$\varphi = \text{arccos } (n_{eff}/n_{ROR1}) \tag{2}$$

We further propose using the entire range of propagation angles $\varphi$ for directional spontaneous emission, and accordingly the entire range of the ratios ($n_{eff}/n_{ROR1}$). Relations (1) and (2) determine the lower bound for the angle $\varphi$ ($\varphi$ greater than zero). We propose to determine the upper bound for the propagation angles in question, $\varphi max$, using the relations:

$$\text{arccos}(n_{eff}/n_{RORI}) \le \text{arccos } (n_{eff\text{-}min}/n_{ROR1}) \ \varphi_{max} \tag{3}$$

$$n_{eff\text{-}min} \text{ is greater than } n_{min} \tag{4}$$

where $n_{eff\text{-}min}$ is the minimum value of $n_{eff}$ of all possible $n_{eff}$ for the multitude of heterostructures 2 with radiation output regions 7 that are of practical value, and $n_{min}$ is the smallest of the refractive indices in the cladding layers of the heterostructure. Numerical calculations we carried out for some heterostructures that are of practical use, such as ones based on compounds InGaAs/GaAs/AlGaAs, showed that the maximum leakage angle $\varphi_{max}$ is approximately equal to 30° to 35°.

The angle of divergence $\Delta\varphi$ in the vertical planes for spontaneous emission propagating in the output region is determined by the spectral dispersion (i.e., by the spread in the propagation angle $\varphi$ as a function of the wavelength $\lambda$, that varies within the spectral band $\Delta\lambda$ for spontaneous emission) and by diffraction. The angle of dispersion-limited divergence $\Delta\varphi_1$ may be determined by a numerical calculation using formula (2) for known dependences of the refractive indices $n_{eff}$ and $n_{ROR1}$ on the wavelength $\lambda$ (within the range $\Delta\lambda$). The angle of diffraction-limited divergence $\Delta_{\varphi2}$, when using a known approximate relationship [H. C. Casey and M. B. Panish, *Heterostructure Lasers, Pt. 1* [Russian translation], Izdat. Mir, Moscow (1981), pp. 89-97], may be written as

$$\Delta\varphi_2 \approx \Upsilon \cdot \lambda/(n_{eff} D_{IR} \cdot \sin \varphi), \tag{5}$$

where $\gamma$ is a numerical coefficient indicating at what radiation intensity level the angle $\Delta\varphi$ is determined ($\gamma$ is equal to unity for level 0.5, and $\gamma$ is equal to two for level 0.1), and $D_{IR}$ is the size of the injection region in the plane of the active layer in the selected direction. The total angle of divergence $\Delta\varphi$ for radiation in the vertical plane inside output region 7 is equal to ($\Delta\varphi_1 + \Delta\varphi_2$). The angle of divergence $\Theta_1$ for the output radiation in the vertical plane outside the output region is determined using the familiar Fresnel formulas [R. W. Ditchburn, *Physical Optics* [Russian translation, Ditchburn's *Light]*, Izdat. Nauka, Moscow (1965), pp. 398-402], and specifically $\Theta_1$ is approximately equal to arcsin [$n \cdot \sin$ ($\Delta\varphi$]. Considering that the angle $\Delta\varphi$ is small, the angle $\Theta_1$ can be estimated as

$$\Theta_1 \approx (n_{ROR1}/n_0) \cdot \Delta\varphi \tag{6}$$

where $n_0$ is the refractive index of the medium bounding the output surface (for air, $n_0$ is equal to unity).

For the directional spontaneous emission obtained, its input efficiency $\eta_{in}$ in the output region is determined by the ratio of the number of spontaneous photons, traveling at propagation angles from ($\varphi - \Delta\varphi/2$) to ($\varphi + \Delta\varphi/2$) from the injection region to the output region, to the total number of spontaneous photons in the injection region. We found that $\eta_{in}$ can be defined as

$$\eta_{in} = (g - \alpha_{IR} - \alpha_{end})/g = \alpha_{OR}/(\alpha_{OR} + \alpha_{IR} + \alpha_{end}), \tag{7}$$

where g (cm$^{-1}$) is the gain for the radiation in the heterostructure due to the injection current density $j$ (A/cm$^2$), $\alpha_{IR}$ (cm$^{-1}$) is the optical loss factor determined by absorption and scattering of radiation within the injection region, $\alpha_{end}$ (cm$^{-1}$) is the loss factor determined by radiation leaking through the end boundaries of the injection region, and $\alpha_{OR}$ is the net loss factor for outgoing directional spontaneous emission leaking from the injection region to the output region. Consequently, the input efficiency $\eta_{in}$, determining to a significant extent the external efficiency of the Emitter, is mainly controlled by the thickness and/or the composition (refractive index) of the cladding sublayers adjacent to the output region. If we choose g >> ($\alpha_{IR} + \alpha_{end}$) or equivalently $\alpha_{OR}$ >> ($\alpha_{IR} + \alpha_{end}$), then we may obtain $\eta_{in}$ close to unity. Depending on the characteristics of the cladding layers, either one-sided or two-sided output of spontaneous emission from the injection region can be realized.

The underlying assumption of the present invention, that an appropriate choice for the heterostructure can result in generation of narrowly directed spontaneous emission, is not obvious. It is widely believed that spontaneous emission within a heterostructure is nondirectional because of the random nature of propagation of individual spontaneous photons (see, for example, [Yu. R. Nosov, *Optoelectronics* [in Russian], Moscow, Izdat. Radio i Svyaz (1989), p.141]). We have experimentally demonstrated and confirmed by computation that upon implementation of our proposed aggregate of essential features for the proposed Emitter, we achieve a narrow radiation pattern for the spontaneous emission in the vertical planes with subsequent efficient output of the emission, which leads to ultrahigh external efficiency, power, optical power, radiation intensity, and optical radiation intensity; the ability to output radiation in different controllable directions, including in the direction perpendicular to the active layer; realization of multibeam Emitters, including linear and two-dimensional emitter arrays with independently controllable beams.

All the noted essential features of the invention made it possible to realize the proposed Emitter in various modifications, considered below, and specifically modifications having different compositions, widths, thicknesses, and numbers of layers, sublayers, and regions belonging both to the heterostructure and to the output region, and also to realize various different as well as unusual configurations of the output region in order to obtain high-efficiency output of directional spontaneous emission.

In selecting the design of the output region, we started from the fact that with the distinctive features we have introduced, the spontaneous emission has a narrow radiation pattern in the vertical planes, but in the corresponding horizontal planes, its propagation is equally likely (within a range of $2\pi$) in any direction (in contrast to the leaky mode in injection lasers). (Here, as in the known emitter [F. A. Kish et al., Appl. Phys. Lett., v.64, No.20, pp.2839-2841, (1994)], the horizontal plane is defined as the plane perpendicular to the corresponding vertical plane, which in turn is perpendicular to the plane of the active layer). This determined the dependence of the output efficiency of spontaneous emission from the output region on its configuration and in turn on the angles of inclination $\psi$ made by the generatrices of the lateral surface of the radiation output region with its inner surface. The highest efficiency can be achieved if we select the output region in the form of a solid of revolution relative to the axis perpendicular to the plane of the injection region and passing through its center, for example, as a truncated right cone or a right circular cylinder. Different directions of the radiation output (relative to the plane of the active layer) are realized by appropriately choosing the angles of inclination $\Psi$, depending on the angle $\varphi$. In individual cases, the output region may be implemented not only as a solid of revolution, but also, for example, as a hexahedron, but in this case the radiation output efficiency from the output region will be reduced.

The problem addressed is also solved in the following cases. The active layer may be formed of at least one sublayer. The cladding layers, disposed respectively on the first and opposite second surfaces of the active layer, are formed of the cladding sublayers Ii and IIj respectively, where $i$ = 1, 2 ... $k$ and $j$ = 1, 2, ... $m$ are defined as integers that designate the sequential numbers labeling the cladding sublayers, as counted from the active layer, with refractive indices $n_{Ii}$ and $n_{IIj}$, respectively, and at least one cladding sublayer is made in each cladding layer. In this case, heterostructure designs are possible in which at least one cladding sublayer may be implemented as a gradient layer, that is, with a monotonically varying composition. Such a gradient cladding layer is considered as a finite number of sublayers of a cladding layer with corresponding $n_{Ii}$ and $n_{IIj}$, obtained by subdividing each gradient layer. The proposed heterostructure designs, for which the active layer may be made as one or several active sublayers (including sublayers having quantum-sized thicknesses), isolated from each other by barrier sublayers, and the cladding layer may be made as a gradient layer, or consisting of one or several sublayers, make it possible to increase the internal efficiency of conversion of injected nonequilibrium carriers to spontaneous photons and to thus increase the efficiency of the Emitter as a whole.

The solution to the addressed problem is also achieved as follows. At least one injection region is made in the working amplifier. The injection region in the working device in practice coincides with the active layer for the portion of it (the area) in which injection of nonequilibrium carriers occurs. The presence of a series of injection regions makes it possible to create multibeam Emitters.

In the preferred embodiments, the thickness of the cladding layer adjacent to the radiation output region is selected to be less than the thickness of the cladding layer disposed on the opposite side of the active layer and/or the refractive index of the cladding sublayer adjacent to the radiation output region is selected to be greater than the refractive index of the outer cladding sublayer, disposed on the opposite side of the active layer.
The proposed development of the features of the invention results in unidirectional propagation of spontaneous emission from the injection region to the radiation output region, with substantial improvement of the directionality and an increase in the external efficiency.

Of course, the direct projection of the injection region onto the inner surface of the output region should not go beyond its limits. The choice of the thickness $d_{ROR1}$ depends on the propagation angle $\varphi$, the maximum dimension of the injection region $D_{IR}$, and the angles of inclination $\psi$. Accordingly, in the preferred embodiments of the Emitter, in order to solve the problem addressed, it is expedient: to select the dimensions and area $S_{IR}$ of the injection region to be no greater than the dimensions and area $S_{in}$ of the introduced inner surface of the radiation output region, adjacent to the corresponding cladding layer of the heterostructure, and to select the thickness of the radiation output region $d_{RORq}$ from the range 1 to 10,000 μm.

In a number of cases: the radiation output region should be implemented as electrically conductive, and ohmic contact should be made to the introduced outer surface of the radiation output region. This makes it possible to simplify the fabrication technology for the Emitter.

In preferred embodiments of the Emitter, in order to solve the problem addressed, the radiation output region is made of optically homogeneous material. The requirement that the output region be transparent to the spontaneous emission means that for efficient operation of the Emitter, we need to have small optical losses due to absorption and scattering of spontaneous emission in the output region. For an output region consisting of a single layer, this will be the case if the following condition is satisfied:

$$\alpha_{ROR1} << (\mu^{.} D_{in})\text{-}1 \tag{8}$$

where μ is a number which, depending on the configuration of the output region, may vary approximately from 0.4 to 1.5; and $D_{in}$ is the dimension of the inner surface of output region in the selected direction. For example, for semiconductive materials, the bandgap $E_{ROR1}$ for the output region should be greater than the bandgap $E_a$ of the active layer, which is determined by the wavelength λ. In cases when in order to achieve low values of $\alpha_{ROR1}$ (cm$^{-1}$) the output region becomes nonconducting, it is expedient to make the radiation output region from at least two layers, where the first layer, bordering the heterostructure, is made electrically conductive and the second layer is made from a material having a lower optical loss factor $\alpha_{ROR2}$ than $\alpha_{ROR1}$ for the first layer, and in this case the second layer may be made insulating. The above makes it possible to increase the efficiency of the Emitter as a result of the reduction in the optical losses due to absorption and scattering of radiation as it passes through the output region.

We can control propagation of radiation in layers of the output region, and consequently the thickness of the output region and its layers, by selecting different refractive indices $n_{ROR1}$ for the first layer and $n_{ROR2}$ for the second layer. In this case, in the first layer, radiation propagates at a propagation angle ($\varphi$ equal to arccos ($n_{eff}/n_{ROR1}$) (see (2)), and in the second layer it propagates at a propagation angle $\varphi2$ equal to arccos ($n_{eff}/n_{ROR2}$) (see (2)). Analogously, for the *q*-th layer of the output region, the following relation is satisfied:

$$\varphi q = \arccos ( n_{eff}/n_{RORq}) \tag{9}$$

Thus the angle of propagation $\varphi q$ at the boundary between two layers of the output region will change on either side. For example, for an output region consisting of two layers, if the refractive index $n_{ROR2}$ of the second layer is selected to be less than the refractive index $n_{ROR1}$ of the first layer, bordering the heterostructure, then the angle $\varphi 2$ will be greater than the angle $\varphi$. For the opposite case: when $n_{ROR2}$ is greater than $n_{ROR1}$, then the thickness of the second layer can be made smaller than in the preceding case, which leads to a decrease in the thickness of the output region, and also to simplification of the fabrication technology and reduction in the fabrication costs for the Emitter. Another proposed approach to decreasing the angle of propagation $\varphi q$ involves introducing sublayers $I_i$ and/or $II_j$ with refractive index greater than $n_{eff}$ into the cladding layers of the heterostructure, having in aggregate with the adjoining output region an effective refractive index $n_{eff}$.

Further, to accomplish our objective, we propose: that at least one layer of the radiation output region may be made from semiconductor and that at least one layer of the radiation output region be made from introduced substrate. This results in simplification of the fabrication technology for the Emitters.

In all the cases considered above of a multilayer output region with electrically conductive first layer, ohmic contact is made to the first electrically conductive layer of the output region, which results in reduction of thermal losses due to resistance and simplification of the fabrication technology for the Emitters. In this case, the thickness of the electrically conductive layer is expediently made as no greater than the minimum linear dimension of the injection region. The efficiency of using the proposed embodiments of the ohmic contact depends on the dimensions of the injection region and on the current densities passing through the proposed Emitter. We also note that, in the general case, the output region may be made of not only semiconductive materials. It is only important that its characteristics, in particular the refractive index $n_{ROR1}$ (in the general case, $n_{RORq}$ (see (9)) and the optical loss factor $\alpha_{RORq}$, meet the necessary requirements (1) and (8).

The problem addressed is also solved using various proposed modifications of the output region designs. A design is proposed in which the radiation output region is implemented as at least one truncated right circular cone, one of whose bases is disposed on the cladding sublayer adjacent to it. The lateral surface of the cone is formed by its generatrices. In an Emitter with such an output region, we can realize different directions for the output radiation and obtain maximum efficiencies, radiation power and intensity for normal incidence of the radiation on the output surfaces. In this case, it is also proposed:

- in order to obtain a direction of radiation output at propagation angle ($\varphi$ relative to the plane of the active layer, that the linear angles of inclination $\psi$ made by the generatrices of the lateral surface of the radiation output region with its inner surface be selected from the range from $(\pi/2 - \varphi - \sigma)$ to $(\pi/2 - \varphi + \sigma)$, where $\varphi$ is the angle made with the plane of the active layer by the normal to the front for radiation propagating within the radiation output region, and $\sigma$ is the angle of total internal reflection on the output surface for radiation propagating within the radiation output region,

- in order to obtain a direction of radiation output at a right angle relative to the plane of the active layer on the side where the radiation output region is disposed, that the linear angles of inclination $\psi$ made by the generatrices of the lateral surface of the radiation output region with its inner surface be selected from the range from $(3\pi/4 - \varphi/2 - \sigma/2)$ to $(3\pi/4 - \varphi/2 + \sigma/2)$,

- in order to obtain a direction of radiation output at a right angle relative to the plane of the active layer on the side where the heterostructure is disposed, that the linear angles of inclination $\psi$ made by the generatrices of the lateral surface of the radiation output region with its inner surface be selected from the range from $(\pi/4 - \varphi/2 - a/2)$ to $(\pi/4 - \varphi/2 + \sigma/2)$.

The problem addressed is also expediently solved by implementing the output region as at least one right circular cylinder, one of whose bases is disposed on the cladding layer adjacent to it, which permits simplification of the fabrication technology and achievement of high values of the characteristics for the Emitter when using directional multiple reflections in the output region.

An emitter is also proposed in-which the output region is formed as at least one hexahedron, one of whose bases is disposed on the cladding layer adjacent to it; in this case it is expedient:

- that the linear angle of inclination $\psi$, made on at least one of the lateral surfaces of the hexahedron with the inner surface of the output region, be selected from the range from $(\pi/2 - \varphi - \Delta\varphi/2)$ to $(\pi/2 - \varphi + \Delta\varphi/2)$, where $\Delta\varphi$ is the

angle of divergence for the radiation in the vertical plane,

- that the linear angle of inclination ψ, made on at least one of the lateral surfaces of the hexahedron with the inner surface of the output region, be selected from the range from (3π/4 - φ/2 - Δφ /2) to (3π/4 - φ/2 + Δφ/2),
- that the linear angle of inclination ψ, made on at least one of the lateral surfaces of the hexahedron with the inner surface of the output region, be selected from the range from (π/4 - φ/2 - Δφ/2) to (π/4 - φ/2 + Δφ/2),
- that the linear angle of inclination ψ, made on at least one of the lateral surfaces of the hexahedron with the inner surface of the output region, be selected as equal to π/2. Choosing the design of the output region as a hexahedron makes it possible to simplify the fabrication technology and also to reduce the area of the near-field radiation while simultaneously increasing the brightness of the Emitter.

Note that for all Emitters in which the output region is made as a right circular cylinder or as a hexahedron, the output surface of which is perpendicular to the plane of the active layer, the propagation angle φ should be selected as less than the angle of total reflection σ, which makes it possible to eliminate total internal reflection of radiation exiting from the radiation output region on the output surface and the corresponding losses.

Further, it is proposed: that antireflective coatings be applied on at least part of the introduced output surfaces, and also that reflective coatings be applied on part of the output surfaces which makes possible an additional increase in the efficiency, power, intensity, and brightness of the Emitter.

Modifications of the Emitter are also proposed with a plurality of output beams of directional radiation. These modifications are distinguished from the preceding modifications in that during their fabrication, in the heterostructure at least two injection regions are formed with identical propagation angles φ, and when current is independently supplied for independent control of the beams, an independent ohmic contact to each injection region is made on the outer side of the heterostructure.

For one modification of the multibeam Emitter, for each injection region with an independent ohmic contact, an associated radiation output region may be formed.

For another modification of the multibeam Emitter, one common radiation output region may be formed at least for some of the injection regions, both with and without independent contact.

The problem addressed is also solved as follows, in order to fabricate Emitters with a linear sequence of output beams of directional spontaneous emission, including those with independent connections to the current supply:

- injection regions of identical dimensions with independent contacts are regularly spaced in the heterostructure along a single line, as a linear sequence of injection regions;
- on the radiation output region side, at least on part of their outer surfaces, metallization layers are introduced that are implemented in the form of strips that electrically connect the injection regions included in the linear sequence.

To fabricate emitters with a two-dimensional array of output beams of directional spontaneous emission, including those with independent connections to the current supply, the problem addressed is solved by:

- forming at least two linear sequences of injection regions in the heterostructure;
- on the side where the injection regions are disposed, implementing the metallization layers on their independent contacts as strips, each of which electrically connects one injection region from each linear sequence of injection regions.

To increase the efficiency by reducing losses of nonequilibrium carriers due to their spreading and surface recombination, the injection region is expediently limited in size by means of introduced barrier layers, at least all the way to the active layer inclusive.

For more effective matching of the emitters to the power source by series galvanic connection of the injection regions, it is proposed that at least two adjacent injection regions be galvanically isolated all the way to the insulating second layer of the output region, and that the ohmic contacts of the aforementioned injection regions be galvanically connected by the metallization layer.

The essence of the present invention is an original design for a heterostructure formed with appropriately selected compositions, thicknesses, number of layers and sublayers, and also a nonobvious implementation of the radiation output region, made from materials with specified refractive indices and number of layers, which made it possible to generate directional spontaneous emission with subsequent efficient output of the radiation from the output region. The output efficiency is additionally increased by selection of appropriate angles of inclination ψ of the generatrices of the lateral surface of the output region. All the above made it possible to increase external efficiency, power, optical power, radiation intensity, and optical radiation intensity of the injection incoherent emitter, and also to achieve highly directional spontaneous emission in different radiation output directions, including design of a multibeam emitter, linear and two-dimensional emitter arrays, including those with beams that can each be independently switched on, with simplification of the technology for making them.

Note that the technical realization of the invention is based on known basic production processes, which by now are well developed. The range of radiation wavelengths for emitters currently in use extends from infrared to ultraviolet radiation. The appropriate heterostructures are used for different portions of the wavelength range. For ultraviolet, blue, and green emission (0.36 µm < λ < 0.58 µm), the most effective heterostructures are those based on semiconductor compounds in the system AlGaN/GaN/GaInN and also ZnCdSSe/GaAs; for red and yellow (0.58 µm < λ < 0.69 µmi), compounds in the system AlGaInP/GaAs; for infrared (0.77 µm < λ < 1.2 µm), compounds in the system AlGaAs/GaAs and in the system InGaAs/GaAs/AlGaAs; for infrared (1.2 µm < λ < 2.0 µm), compounds in the system GaInAsP/InP; for infrared (2.0 µm < λ < 4.0 µm), compounds in the system AlGaInSbAs/GaAs. In each of the indicated ranges, depending on the λ used and the selected heterostructure, appropriate materials for the output region must be selected that satisfy conditions (1) and (8). We may suggest the following semiconductor materials for the output region: for the system AlGaN/GaN/GaInN — GaN; for the system ZnCdSSe/GaAs — ZnSe; for the system AlGaInP/GaAs — GaP; for the system AlGaAs/GaAs — GaP; for the system InGaAs/GaAs/AlGaAs — GaAs and Gap; for the system GaInAsP/InP - Si and GaAs; for the system AlGaInSbAs/GaAs — Si and GaAs. The recently developed "wafer bonding" technology (see, for example, H. Wada et al., IEEE Photon. Technol. Lett. v.8, p.173, (1996)) can be used to successfully implement these suggestions. The designs of efficient Emitters with directional spontaneous emission proposed by the present invention are applicable at least for all the above-indicated radiation wavelength ranges and heterostructure systems. White light emitters used for illumination may be obtained as follows: either by mixing radiation of the three basic colors (red, green, and blue), or by excitation of red and green luminescent radiation from a blue light Emitter in a material especially selected for this purpose.

Brief Description of the Drawings

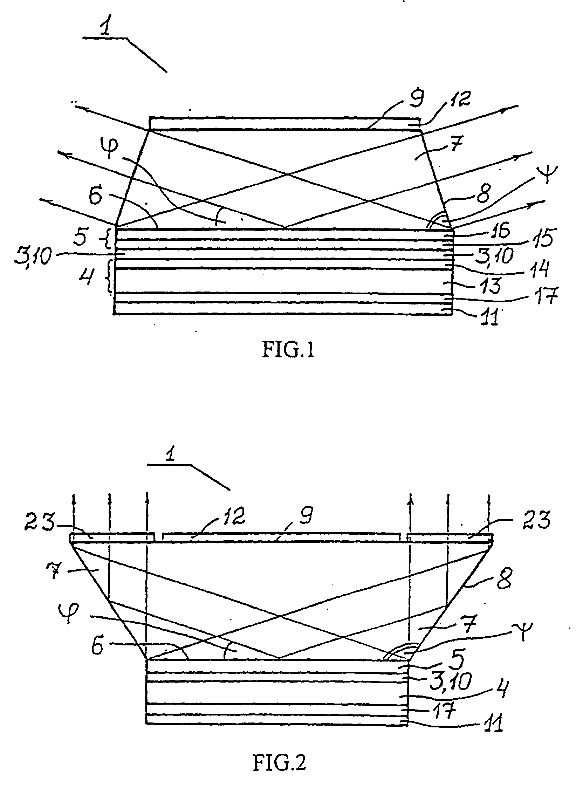

The present invention will be understood from Figures 1-18.

Figures 1-3 schematically depict axial sections of the emitter, passing through the central symmetry axis of the radiation output region, made in the form of a truncated right circular cone, where the generatrices of the lateral surface of the radiation output region make the following linear angles of inclination ψ with its inner surface:

Fig. 1- $(\pi/2 - \varphi)$;
Fig. 2 - $(3\pi/4 - \varphi/2)$;
Fig. 3 - $(\pi/4 - \varphi/2)$.
Figure 4 schematically depicts an axial section, passing through the central symmetry axis of the radiation output region, made in the form of a right circular cylinder.
Figures 5-6 schematically depict axial sections along one of the lateral sides of the emitters, whose output region is in the form of a rectangular parallelepiped, and specifically:

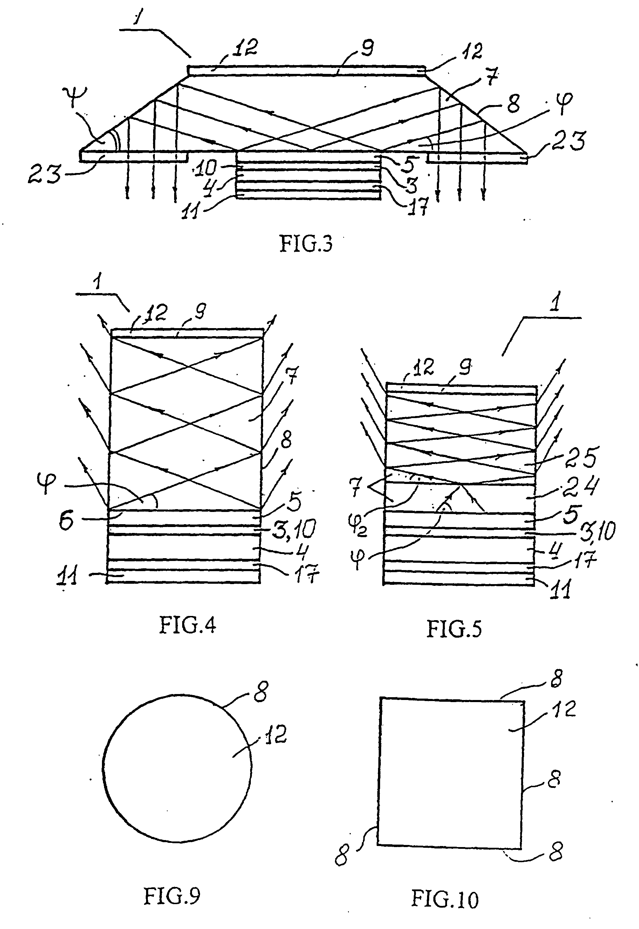

Fig. 5: it is made from two electrically conductive layers, where the refractive index $n_{ROR2}$ of the second layer is greater than the refractive index $n_{ROR1}$ of the first layer, bordering the heterostructure;

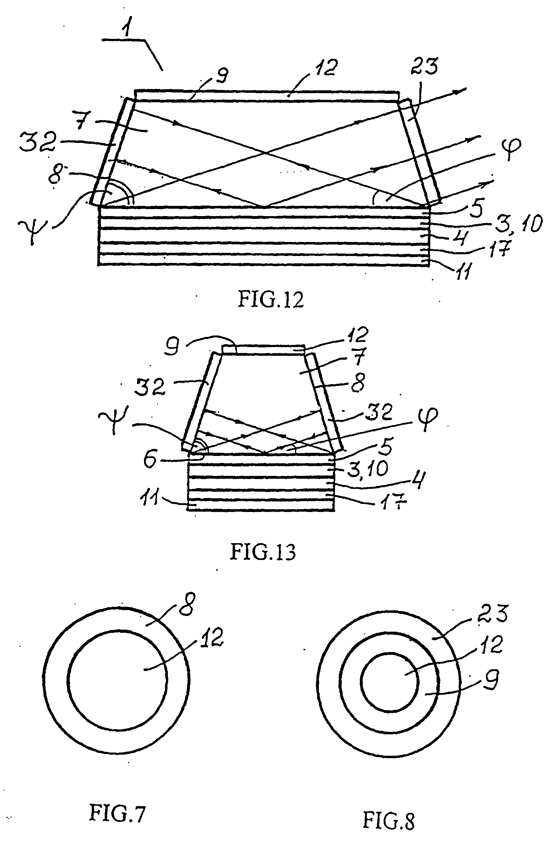

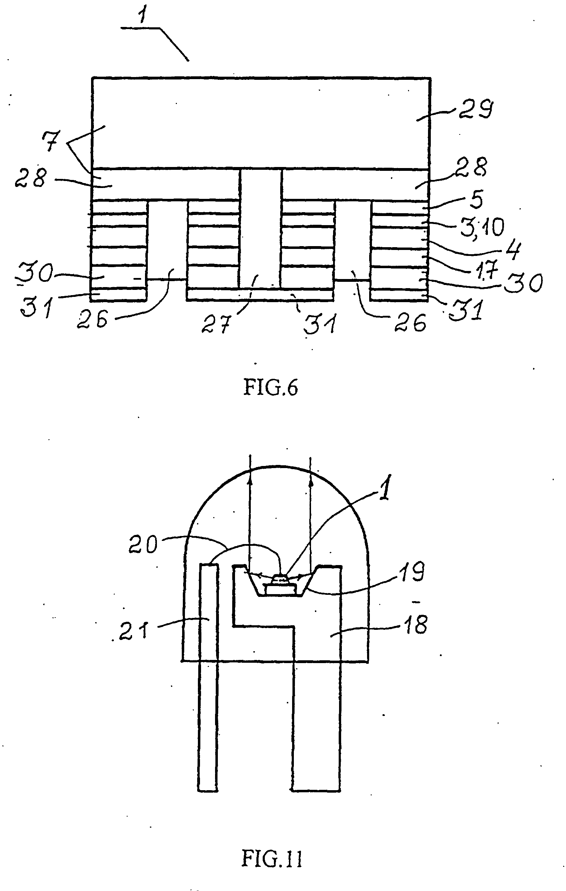

Fig. 6: it is made from two layers, the first layer is electrically conductive, the second layer is insulating, and the injection layers in this case are galvanically connected in series.

Figures 7, 8, 9, and 10 schematically depict top views (as viewed from the output region) for Emitters whose axial sections are depicted in Figs. 1, 2, 4 and 5 respectively.
Figure 11 schematically depicts a transverse cross section of the proposed emitters, mounted on a holder.
Figures 12 and 13 schematically depict respectively a longitudinal section and a transverse cross section of the Emitter with small nearfield radiation area and high brightness of the radiation, for which the radiation output is effected through one lateral facet of the hexahedral radiation output region.

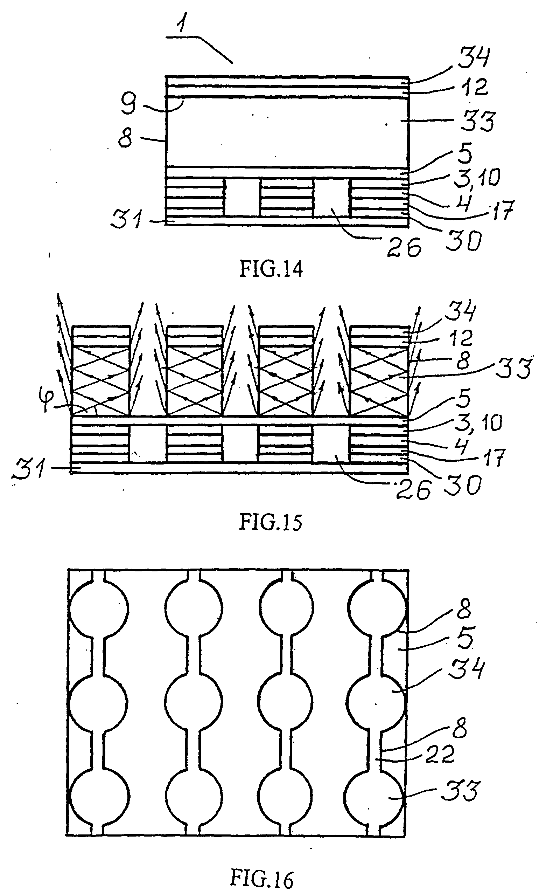

Figures 14, 15, and 16 schematically depict respectively the sections along and perpendicular to the length of the linear sequence of injection regions, and also a top view for the Emitter with a plurality of spontaneous emission beams, for which a common output region is made for each linear sequence of injection regions, in the form of a plurality of regularly spaced and interconnected right circular cylinders.

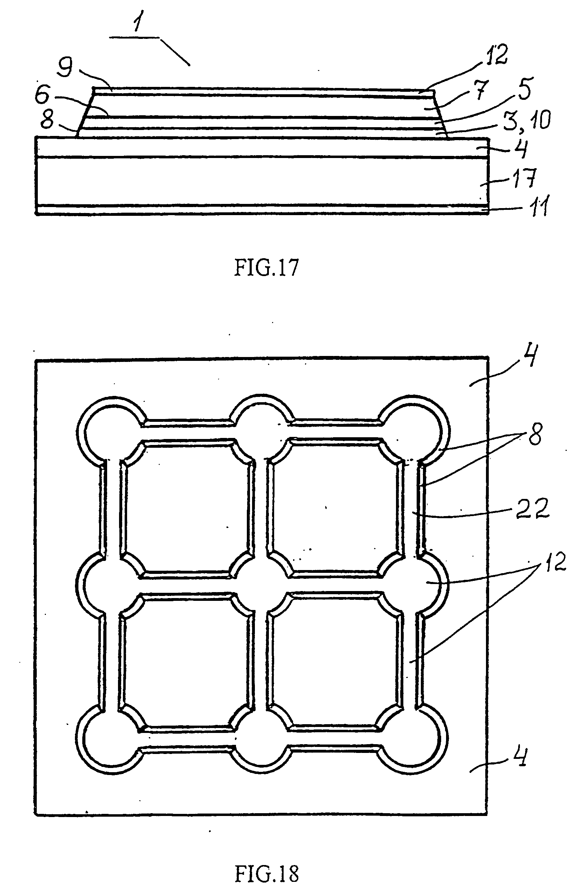

Figs. 17 and 18 schematically depict respectively a section along the symmetry plane and a top view for an Emitter whose output region is made as a plurality (nine) of regularly spaced and interconnected truncated right circular cones.

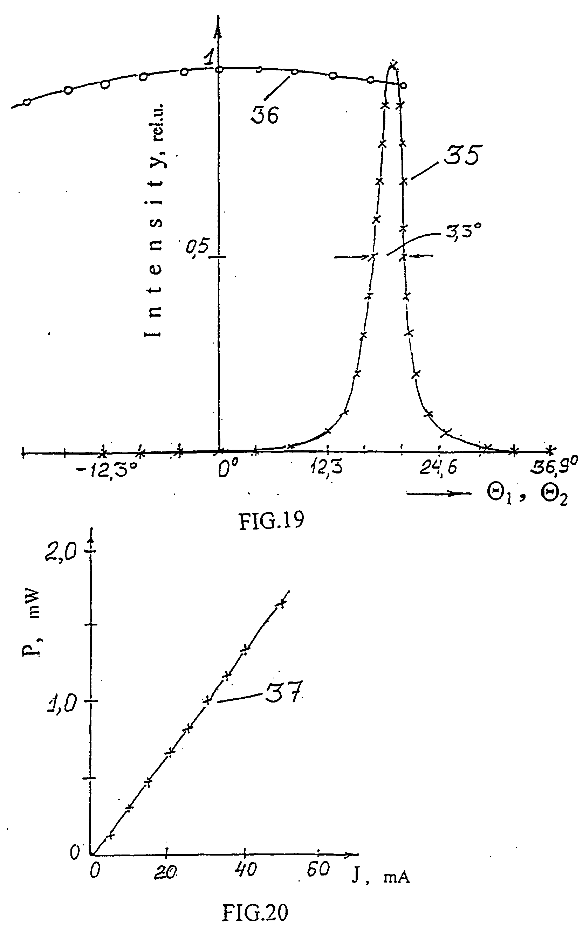

Figure 19 presents the results of experimental measurements of the angles of divergence of the radiation in the vertical ($\Theta_1$) and the horizontal ($\Theta_2$) planes.
Figure 20 presents the radiation power vs. the current passing through an experimental model of the emitter.

Embodiments of the Invention

In the following, the invention is explained by specific embodiments, with references to the attached drawings. The examples presented for the design of the Emitter are not the only embodiments, and suggest other embodiments whose particular details are reflected within the aggregate of features in the claims.

The proposed Emitter 1, one of whose modifications is schematically depicted in Fig. 1 and Fig. 7, includes heterostructure 2, grown by the known MOC-hybrid epitaxy (MOCVD) method and consisting of active layer 3, disposed between cladding layers 4 and 5, with sublayers $I_i$ and $II_j$ respectively, where $i = 1 ... k$ and $j = 1 ... m$. Active layer 3 in this case consists of several active sublayers and barrier sublayers separating them (not shown in Fig. 1). The inner surface 6 of semiconductor output region 7, having the shape of a truncated right circular cone with lateral surface 8, the angles of inclination $\psi$ of the generatrices of which are equal to 72°, is disposed on the surface of sublayer $II_m$ of cladding layer 5 that is remote from active layer 3. The height of the cone is equal to 921 μm. The bottom circular base of the cone, of diameter 3000 μm, is the inner surface 6 of output region 7. The top base of the cone for output region 7 (the circle of smaller diameter, equal to 2401 μm) is the outer surface 9 of output region 7. Injection region 10 in this emitter coincides with active layer 3 (their areas are equal) and has a circular shape; its diameter $D_{IR}$ is equal to 3000 μm, its area $S_{IR}$ is equal to 0.07065 cm$^2$, and its thickness is equal to the thickness of active layer 3. Ohmic contact 11 is made to the construction on the side opposite the location of output region 7, and ohmic contact 12 is made to the outer surface 9. Cladding layer 4 in this design consists of sublayers 13 ($I_1$) and 14 ($I_2$), and cladding layer 5 consists of sublayers 15 ($II_1$) and 16 ($II_2$). A semiconductor contact layer 17 is disposed on the surface of sublayer $I_k$ of cladding layer 4 that is remote from active layer 3, and specifically, on sublayer 14. Note that when fabricating the Emitter proposed in the present invention on heterostructures 2 made from other semiconductor compounds, for example, GaInAsP/InP (see p. 14), the contact layer 17, designed to reduce the ohmic resistance of the Emitter, may not be required. The Table gives the composition, thicknesses, refractive indices, type, doping concentrations, and absorption coefficients of the layers and sublayers of heterostructure 2, as well as for contact layer 17 and output region 7 (see p. 24). The radiation wavelength $\lambda$ for this composition of active layer 3 of heterostructure 2 (see Table) is equal to 604 nm.

In Fig. I and also on the following Figs. 2-5, 12, 13, and 15, conventional arrows indicate the directions of propagation of the laser radiation in output region 7 and outside it. The linear angles of inclination $\psi$ between the inner surface 6 and lateral surface 8 are arbitrarily taken as going in the direction away from inner surface 6.

As one possible embodiment, Emitter 1 was mounted by the side of ohmic contact 11 using, for example, conductive silver-containing paste, on holder 18 (being at the same time an electrical lead) with conical tilted reflective walls 19 (see Fig. 11). Ohmic contact 12 through wire 20 was connected to the other electrical lead 21. The required power was supplied to ohmic contacts 11 and 12. The holder with Emitter 1 may be potted with transparent insulating compound (not shown in Fig. 11) having refractive index $n_0$ equal to 1.5.

The basic parameters for this and subsequent Emitters 1 were obtained by numerical calculations. The effective refractive index $n_{eff}$, the propagation angle $\varphi$, the gain $g$ for the radiation, and also the angle of dispersion-limited divergence $\Delta_{\varphi 1}$ for directional spontaneous emission were calculated using a special program based on the matrix method [J. Chilwall et al., J. Opt. Sos. Amer., A. v.1, No.7, pp.742-753, (1984)] for solving Maxwell's equations with the appropriate boundary conditions in multilayer heterostructures.

Specifically, for Emitter 1 with characteristics of the layers of heterostructure 2 and output region 7 given in the Table, we found that:

- the effective refractive index $n_{eff}$ is 3.2921,
- the propagation angle ($\varphi$ is 18°,
- the gain g for radiation in the active layer that is achieved for a current density through the device $j$ of 100 A/cm$^2$ is equal to 391 cm$^{-1}$,
- the angle of dispersion-limited divergence $\Delta_{\varphi 1}$ for spontaneous emission within output region 7 is equal to 11.6 mrad (for the numerical calculation, we assumed that the half-width of the spectral line for spontaneous emission is equal to 20 nm).

The angle of diffraction-limited divergence $\Delta_{\varphi 2}$ (5) was found to be equal to only 0.2 mrad, and taking this into account, the total angle of divergence $\Delta_\varphi$ within output region 7 is equal to 11.8 mrad. The angle of divergence $\theta_1$ in the vertical plane, after exit of the radiation from output region 7, according to (6) is equal to 40.8 mrad (2.3°). The nearfield radiation for the output spontaneous emission has the shape of an annular surface located on lateral surface 8 of output region 7, the width of the ring is equal to 930 μm and its total area is equal to 0.028 cm$^{-2}$. The output radiation over the entire perimeter of the ring is tilted at an angle equal to the angle ($\varphi$ (18°) relative to the plane of active layer 3.

The external efficiency $\eta$ was calculated using a formula obtained for the embodiment of Emitter 1 with normal incidence of the spontaneous emission on the output surface:

$$\eta = \eta_i \cdot \eta_{in} \cdot \eta_\alpha \cdot (1- R) \cdot [1 + (\eta_{in} \cdot \eta_\alpha{}^2 \cdot R)^1 + (\eta_{in} \cdot \eta_\alpha{}^2 \cdot R)^2 + (\eta_{in} \cdot \eta_\alpha{}^2 \cdot R)^3 + ...] \qquad (10)$$

where $\eta_i$ is the internal quantum efficiency, defined by the ratio of the number of spontaneous emission photons generated to the number of injected electron—hole pairs, $R$ is the reflection coefficient for spontaneous emission on the output surface of output region 7 for normal incidence on said surface,
$\eta_\alpha$ is the efficiency, determining the optical losses for the radiation (absorption, scattering) for a single pass through output region 7, equal to

$$\eta_\alpha = \exp(-\alpha_{ROR1} \cdot \mu \cdot D_{in}) \qquad (11)$$

where $\mu$ is a number which, depending on the configuration of the output region, may vary approximately from 0.4 to 1.5; $D_{in}$ is the diameter of inner surface 6 of output region 7.

Formula (7) was used to calculate $\eta_{in}$. In the calculations, we assumed that the coefficients $\eta_i$, $\alpha_{IR}$, and $\alpha_{ROR1}$ were equal respectively to unity (as is usually the case in high-quality heterostructures), 5 cm$^{-1}$, and 0.6 cm$^{-1}$ [R. K. Willardson and A. C. Beer, eds., Optical Properties of Semiconductors [Russian translation, Semiconductors and Semimetals, Vol. 3: Optical Properties of III-V Compounds], Izdat. Mir, Moscow (1970), pp. 454-458]. Losses due to escape of spontaneous emission through the end face surfaces of injection region 10 were neglected in the calculations because they were small ($\alpha_{end}$ was assumed to be equal to zero). The efficiencies $\eta_{in}$ (7) and $\eta_\alpha$ (10) were respectively equal to 0.9872 and 0.9180. In the calculation for $\eta_\alpha$ (10), the numerical coefficient $\mu$ was equal to (0.5cos $\varphi$), and specifically 0.4756. The external efficiency $\eta$ for Emitter 1, calculated taking into account the assumptions made, was 0.8608 according to (9). The output power P (watts) for spontaneous emission is determined as

$$P = \eta \cdot J \cdot (h\nu), \qquad (12)$$

where J A is the operating current passing through the injection region, and (h$\nu$) is the energy of a photon of radiation, expressed in volts. The power $P$ (11) of spontaneous emission, determined for a current $J$ equal to 7.065 A, which is achieved for an operating current density of 100 A/cm$^2$, is equal to 12.5 W. The radiation power per unit area for the nearfield radiation is 83.3 W/cm$^2$. Considering the luminous efficiency curve for the emitted wavelength of 604 nm, the power obtained of 12.5 W corresponds to an optical power $P_{opt}$ equal to 4952 lumens. The optical radiation intensity $Q_{opt}$, defined as the ratio of the power $P_{opt}$ obtained to the total solid angle ($2\pi.\Delta\varphi$) within which it emits, is equal to 19327 candelas.

In the next modification of Emitter 1, depicted in Figs. 17 and 18, output region 7 consists of a plurality of regularly spaced truncated right circular cones and "jumpers" 22 (in Fig. 18, it consists of 9 cones and 10 jumpers), connecting the outer surfaces of all the aforementioned cones in two mutually perpendicular directions. Inner surfaces 6 of output region 7, like injection regions 10 that have the same shape and area, are shaped as rings connected by the bottom bases of jumpers 22 and equally spaced on cladding layer 4, separated by twice their circular diameter. Contact layer 17 is made of GaAs substrate. Current is supplied through continuous ohmic contact 11, disposed on contact layer 17, and ohmic contact 12, disposed on outer surface 9 of all the cones and joining their jumpers 22. In this Emitter 1, we can ensure a total thickness of one micron or more for output region 7 by selecting small areas for injection region 10 (say, having a diameter of 10 $\mu$m or more). This makes it possible to simplify the fabrication technology for Emitter 1, since layers of output region 7 can be grown within a single process with heterostructure 2, and they can be formed by chemically-assisted ion beam etching [J. D. Chinn et al., J. *Vac. Sci. Technol.,* Vol. A1, pp. 701-704 (1983)]. At the same time, Emitter 1 (due to small absorption losses in output region 7) has high external efficiency, does not have any fundamental limitations on the size and shape of the light source, and consequently may have high power and optical power for the emission. One or several cones of output region 7 may be made with large diameter for attaching one or several conducting wires 20 on the output region 7 side (not shown in the figures).

In another modification of Emitter 1, depicted in Fig. 2 and Fig. 8, the angles of inclination $\psi$ made by the generatrices of lateral surface 8 of conical output region 7 with the plane of injection region 10 were selected to be equal to $(3\pi/4 - \varphi/2)$, and specifically 126°. As a result, the radiation near field, with the shape of a ring of width 900 $\mu$m, is located along the periphery of outer surface 9, and specifically at the points of projections of lateral surface 8 onto said outer surface 9. The spontaneous emission exits in the direction perpendicular to the aforementioned projection points, onto which antireflective coatings 23 are applied. The coefficient $\mu$ for the Emitter 1 in question is equal to 0.685. This leads to some reduction in the coefficient $\eta_\alpha$, and consequently to some reduction in the coefficient $\eta$. The remaining characteristics are close to the characteristics of the first modification of Emitter 1.

Fig. 3 depicts the next modification of Emitter 1, for which the angles of inclination ψ made by the generatrices of lateral surface 5 of conical output region 7 with the plane of injection region 10 are equal to (π/4 - φ/2), and specifically 36°. As a result, the emission exits through the outer annular portion of inner surface 6 of output region 7, with antireflective coatings 23 applied to it, that is clear of heterostructure 2, contacts 11, and contact layer 17. The coefficient μ = 1.435.

In the next modification of the Emitter (see Figs. 4 and 9), output region 7 is implemented in the form of a right circular cylinder with diameter $D_{in}$ of 3000 μm. This leads to the following consequences. Such an Emitter 1 must include a heterostructure 2 characterized, in aggregate with the adjoining output region 7, by a value of $n_{eff}$ such that the propagation angle φ (2) is not greater than the angle σ, equal to 16°50'. In this Emitter 1, this was achieved by increasing the thickness of sublayers 14 and 15 up to 0.1 μm and decreasing the thickness of layer 16 down to 0.1 μm (see Table). This led to a reduction in the angle (φ down to 16°30'. Further, in contrast to the preceding modifications, in this Emitter 1 some of the spontaneous emission exits while some undergoes multiple reflection from lateral surface 8 before it exits from output region 7 (see Fig. 4). The number of such reflections depends on the reflection coefficient $R_{ob}$ for spontaneous emission on the output surface of output region 7 for oblique incidence thereon, which in turn depends on the angle of incidence of the radiation on lateral surface 8, equal to the angle φ. In the proposed Emitter 1, the rays travel in output region 7 in an orderly manner, which allows the radiation to exit from output region 7 with small losses. We selected the thickness of output region 7 to be 3000 μm, which assured three reflections of the outgoing rays before they reach outer surface 9. The angle of incidence of the radiation on lateral surface 8 of output region 7 was equal to 16°30', and the angle of refraction of the radiation thereon was equal to 79°20'. The other calculation data are: coefficient g is 391 cm$^{-1}$, $\eta_{in}$ is 0.9872, $\eta_\alpha$ is 0.9098, $R_{ob}$ for unpolarized spontaneous emission is 0.4198, and the external efficiency η for three reflections inside output region 7 is equal to 0.8098. The value of η was calculated using the relation obtained for modifications of the Emitter with oblique incidence of spontaneous radiation on the output surface (in particular, with a cylindrical output region):

$$\eta = \eta_i \cdot \eta_{in} \cdot \eta_\alpha \cdot (1- R_{ob}) \cdot [1 + (\eta\alpha \cdot R_{ob})^1 + (\eta\alpha \cdot R_{ob})^2 + (\eta_\alpha \cdot R_{ob})^3 {}_{+} \cdots] \qquad (13)$$

Thus for a current $J$ of 7.065 A ($j$ equal to 100 A/cm$^2$), $P$ (11) is equal to 11.74 W, $P_{opt}$ is equal to 4653 lumens, and $Q_{opt}$ is equal to 18276 candelas.

The output region 7 of another modification of Emitter 1 (see Figs. 5 and 10) is made in the form of a rectangular parallelepiped and consists of two layers 24 and 25, whose refractive indices correspond to relation (1), but in this case the refractive index of layer 25 is greater than in layer 24. Both layers are electrically conducting. Inner surface 6, like injection region 10, has a rectangular shape. The coefficient $R_{ob}$, in contrast to the preceding modifications, in the horizontal plane depends on the angle of incidence of the radiation on the lateral sides of output region 7, and varies within the range from 0.3 to unity. This leads to some decrease in the external efficiency for this modification. The angle of divergence $\theta_2$ for the radiation in the horizontal plane, after the radiation exits from output region 7, will be equal to π radians for each lateral side. The two-layer composition of output region 7 indicated above makes it possible to decrease the total thickness of output region 7. Other characteristics and features of this Emitter 1 are similar to the preceding modification. Note that the Emitter is the simplest to make.

Note that for the modifications of the invention considered above (see Figs. 1-4), in order to simplify the fabrication technology and reduce the cost of the emitters, application of the antireflective coatings 23 to output surfaces of output region 7 may be omitted. Due to multiple reflections from lateral surface 8 of output region 7 (see Figs. 4 and 5 and also formula (12)) or due to multiple re-emissions from injection region 10 of radiation reflected back into it from lateral surface 8 of output region 7 (see Figs. 1, 2 and 3, and also formula (9)), we can obtain an external efficiency (9), (12) that is not much smaller than when the antireflective coatings are present. Also note that to simplify the fabrication technology for the proposed Emitters, their injection regions 10 may be made without barrier regions (see Figs. 1-5).

In individual modifications, more effective matching of high-power emitters to power sources by increasing the supply voltage may be achieved by making injection regions 10 and their galvanic series connection using introduced barrier regions 26 and 27 (see Fig. 6). In this case, output region 7 consists of an electrically conductive layer 28 and an insulating layer 29, and barrier layer 26 on one side of injection region 10 isolates it at least up to cladding layer 5, and barrier layer 27 on the other side isolates it all the way up to insulating layer 29. In this case, independent ohmic contacts 30, for the two adjacent injection regions 10 which are separated by barrier layer 27, are connected in pairs by metallization layers 31 (see Fig. 6).

For a modification of Emitter 1 with a small light source and high radiation brightness (see Figs. 12 and 13), output region 7 is implemented as a hexahedron whose inner surface 6 and outer surface 9 have a rectangular shape. The sides of the rectangle for inner surface 6 are 1000×3000 μm$^2$. Injection region 10 has the same dimensions and the same area. Lateral surfaces 8 of the hexahedron consist of four facets. Antireflective coating 23 is applied to one of the facets with the output surface, and reflective coating 32 is applied to the remaining three facets. All the facets are made with identical angles of inclination $\psi$ equal to ($\pi/2$ -$\varphi$), and specifically 72°. In the operating device, radiation incident on the three facets is reflected and returned back to injection region 10 at the same propagation angle $\varphi$, equal to 18°. Note that the total angle of divergence $\Delta\varphi$, as for the modification according to Fig. 1 considered above, is equal to 0.68° (11.8 mrad). The value of $\Delta\varphi/2$, equal to 0.34°, corresponds to the accuracy to which the tilted facets of output region 7 of Emitter 1 must be made in order to achieve maximum efficiency. An estimate shows that the greater part of this returned radiation will exit from output region 7 through the output surface with approximately the same external efficiency $\eta$ as for Emitter 1 of the first modification considered here. In this case, the power P (11) for current $J$ of 3.0 A will be equal to 5.3 W. The power per unit area obtained for the radiation near field will be equal to 800.6 W/cm$^2$, which is almost ten times higher than for the first modification of Emitter 1. The angles of divergence $\theta_1$ and $\theta_2$ for the Emitter 1 in question in the vertical and the horizontal planes respectively are equal to 2.3° and 90°. The optical radiation intensity $Q_{opt}$ in this case was found to be equal to 19327 candelas.

Note that we can also achieve a decrease in the nearfield radiation area and an increase in its brightness for other modifications of Emitter 1, depicted in Fig. 2 and Fig. 8; Fig. 3 and Fig. 9; Fig. 4; Fig. 5 and Fig. 10, by application of reflective coatings on part of their output surfaces.

For another modification of Emitter 1 with a plurality of independently controllable beams (see Figs. 14, 15, and 16), 200 linear sequences (linear arrays) of injection regions 10, each of which contains 500 injection regions 10, were made on layer 5 of heterostructure 2 with the help of barrier regions 26. The diameter of each injection region 10 is 18 $\mu$m, and they were equally spaced 30 $\mu$m apart, and were disposed in two mutually perpendicular directions. To each linear array corresponds an output region 7 made of a linear sequence of right circular cylinders of diameter 18 $\mu$m, coaxial with each injection region 10 in the linear array, and connected by jumpers 22 to create a common linear output region 7 of thickness 9 $\mu$m. Each rectangular jumper 22 was made of length 12 $\mu$m and width 6 $\mu$m. The total size of Emitter 1 was 15x6 mm$^2$. On outer surfaces 9 of the common output region 7 for each linear array, ohmic contacts 12 with metallization layers 33 were made thereto (200 strips). On the opposite side, independent ohmic contacts 30 were made to injection regions 10, together with the metallization layers 31 (500 strips) connecting them in the direction perpendicular to the length of the linear array. In fabrication of this Emitter 1, we used known planar technology methods, including photolithographic processes with double-sided alignment and chemically-assisted ion beam etching. During fabrication, Emitter 1 was mounted on holder wafers that are not shown in the figures. The calculations performed for this Emitter 1 gave the following results. The output radiation, directed at an angle of 10°40' to lateral surface 8 of output region 7, has divergence $\Delta\varphi$ equal to 9°10'. The external efficiency $\eta$ for three reflections is 0.9566. The power $P$ (11) from a single injection region 10 for a current of 1.017 mA ($j$ of 400 A/cm$^2$) is equal to 2 mW. Each of the radiation beams (out of 10,000 beams) may be switched on independent of the rest. The beam density was 11111 cm$^{-2}$.

Figures 19 and 20 show the results of preliminary measurements for experimental models of the Emitters that we have fabricated, that fully confirm our nonobvious assumption concerning a narrow radiation pattern for the spontaneous emission. The emitters were fabricated on the basis of a specially designed heterostructure (made from the compounds GaInAs/GaAs/AlGaAs) with strong leakage of radiation at a wavelength of 980 nm. The injection region had dimensions 50x500 $\mu$m2. Output region 7 had the shape of a hexahedron with lateral surfaces 8 of three facets with angles of inclination $\psi$ equal to 90° and one output lateral surface 8 on a facet with an angle of inclination $\psi$ equal to 72°. No coating was applied to Emitter 1. From the measurement data (Fig. 19, Curve 35), it follows that the angle of divergence $\Theta_1$ for output spontaneous emission (0.5 level) in the vertical plane is equal to 3.3°, and in this case the emission is tilted relative to the plane of the active layer by a 19° angle (the calculation gave 18.5°). In the horizontal plane, as we should expect, emission is virtually nondirectional (Fig. 19, Curve 36). The results of measurements of the power—current characteristic (Fig. 20, Curve 37) are evidence that it is possible to obtain high efficiency for the Emitters proposed by the present invention. Note that the measurements were made for the first experimental model (a design that was far from optimal), the power was measured from a tilted lateral facet in a 40° aperture, with injection region of width 50 $\mu$m. Also note that in continuous wave (cw) operation, we obtained a linear dependence of $P$ (mW) on the operating current $J$ (mA) all the way up to current densities $j$ equal to 400 A/cm$^2$. This is evidence that the heat dissipation conditions are good in the proposed Emitters.

Commercial Applicability

Injection incoherent emitters are used in information display devices: light indicators, traffic lights, full-color displays, screens, and home projection televisions; in fiber-optic communications and data-transmission systems; in the design of medical equipment, for pumping solid-state and fiber lasers and amplifiers, and also as white light LEDs instead of vacuum incandescent lamps and electroluminescent lamps.

TABLE

| Name, Nos. of layers, sublayers, regions | | | Composition of layer | Thickness of layer $d$ (µm) | Refractive index $n$ | Type of conductivity | Carrier concentration $N_e$ (cm$^{-3}$) | Absorption coefficient $\alpha$ (cm$^{-1}$) |
|---|---|---|---|---|---|---|---|---|
| 1 | | | 2 | 3 | 4 | 5 | 6 | 7 |
| contact layer | 17 | | GaAs | 0.3 | 3.878 | P | $2 \cdot 10^{19}$ | $10^4$ |
| cladding layer, sublayers | 4 | 13 | $Al_{0.7}Ga_{0.3}InP$ | 1.2 | 3.241 | P | $5 \cdot 10^{17}$ | 1.0 |
| | | 14 | $Al_{0.5}Ga_{0.5}InP$ | 0.07 | 3.341 | — | — | 1.0 |
| active layer | 3 | | $Al_{0.22}Ga_{0.78}InP$ | 0.008 | 3.482 | — | — | 1.0 |
| cladding layer, sublayers | 5 | 15 | $Al_{0.5}Ga_{0.5}InP$ | 0.07 | 3.341 | — | — | 1.0 |
| | | 16 | $Al_{0.7}Ga_{0.3}InP$ | 0.2 | 3.241 | N | $5 \cdot 10^{17}$ | 1.0 |
| output region | 7 | | GaP | 921.0 | 3.46 | N | $1 \cdot 10^{18}$ | 0.6 |

**EP 1 158 585 A1**

**Claims**

1. An injection incoherent emitter, comprising a heterostructure containing an active layer, cladding layers, ohmic contacts, and at least on one side of the active layer, adjacent to the corresponding cladding layer, a radiation output region that is transparent to the radiation; said injection incoherent emitter being *distinctive* in that at least one radiation output region of appropriate configuration is made and said output region has at least one layer **characterized by** refractive index $n_{RORq}$, optical loss factor for the radiation $\alpha_{RORq}$ (cm$^{-1}$), thickness $d_{RORq}$ (µm), where $q = 1, 2,..., p$ are defined as integers that designate the sequential numbers labeling the layers of the output region, as counted from its boundary with the heterostructure; and the heterostructure with the adjoining radiation output region is **characterized by** an effective refractive index $n_{eff}$, where the effective refractive index $n_{eff}$ and the refractive index $n_{ROR1}$ are selected to satisfy the relations:

$$\arccos(n_{eff}/n_{ROR1}) \leq \arccos(n_{eff\text{-}min}/n_{ROR1}), \text{ and } n_{eff\text{-}min} \text{ is greater than } n_{min},$$

where $n_{eff\text{-}min}$ is the minimum value of $n_{eff}$ of all possible $n_{eff}$ for the multitude of heterostructures with radiation output regions that are of practical value, and
$n_{min}$ is the smallest of the refractive indices in the cladding layers of the heterostructure.

2. An injection incoherent emitter as in Claim 1, which is distinctive in that the active layer of the heterostructure is formed of at least one sublayer.

3. An injection incoherent emitter as in any of the Claims, which is distinctive in that the cladding layers, disposed respectively on the first and opposite second surfaces of the active layer, are formed of the cladding sublayers I$i$ and II$_j$ respectively, where $i = 1, 2 ... k$ and $j = 1, 2, ... m$ are defined as integers that designate the sequential numbers labeling the cladding sublayers, as counted from the active layer, with refractive indices $n_{Ii}$ and $n_{IIj}$, respectively, and at least one cladding sublayer is made in each cladding layer.

4. An injection incoherent emitter as in Claim 3, which is distinctive in that at least one cladding sublayer of the heterostructure is implemented as a gradient layer.

5. An injection incoherent emitter as in any of the Claims, which is distinctive in that at least one injection region is made in the operating emitter.

6. An injection incoherent emitter as in any of the Claims, which is distinctive in that the thickness of the cladding layer adjacent to the radiation output region is selected to be less than the thickness of the cladding layer disposed on the opposite side of the active layer.

7. An injection incoherent emitter as in any of the Claims, which is distinctive in that the refractive index of the cladding sublayer adjacent to the radiation output region is selected to be greater than the refractive index of the outer cladding sublayer, disposed on the opposite side of the active layer.

8. An injection incoherent emitter as in any of the Claims, which is distinctive in that the dimensions and area $S_{IR}$ of the injection region are selected to be no greater than the dimensions and area $S_{in}$ of the surface of the radiation output region that is adjacent to the corresponding cladding layer of the heterostructure and is called the inner surface.

9. An injection incoherent emitter as in any of the Claims, which is distinctive in that the thickness of the radiation output region $d_{RORq}$ is selected from the range 1 to 10,000 µm.

10. An injection incoherent emitter as in any of the Claims, which is distinctive in that the radiation output region is implemented as electrically conductive.

11. An injection incoherent emitter as in Claim 10, which is distinctive in that an ohmic contact is made to the outer surface of the radiation output region, opposite the inner surface.

12. An injection incoherent emitter as in any of the Claims, which is distinctive in that the radiation output region is made of optically homogeneous material.

14

**13.** An injection incoherent emitter as in any of the Claims, which is distinctive in that the radiation output region is made of at least two layers, and the first layer, bordering the heterostructure, is made electrically conductive, and the second layer is made from a material having an optical loss factor $\alpha_{ROR2}$ that is lower than the optical loss factor $\alpha_{ROR1}$ for the first layer.

**14.** An injection incoherent emitter as in Claim 13, which is distinctive in that the second layer is implemented as insulating.

**15.** An injection incoherent emitter as in Claim 13, which is distinctive in that the refractive index $n_{ROR2}$ of the second layer is selected to be lower than the refractive index $n_{ROR1}$ of the first layer, that borders the heterostructure.

**16.** An injection incoherent emitter as in any of the Claims, which is distinctive in that at least one layer of the radiation output region is made from a semiconductor.

**17.** An injection incoherent emitter as in any of the Claims, which is distinctive in that at least one layer of the radiation output region is made from introduced substrate.

**18.** An injection incoherent emitter as in any of the Claims, which is distinctive in that an ohmic contact is made to the first, electrically conductive layer of the radiation output region.

**19.** An injection incoherent emitter as in any of the Claims, which is distinctive in that the output region is made in the form of at least one truncated right circular cone, one of whose bases is disposed on the cladding sublayer adjacent to it.

**20.** An injection incoherent emitter as in Claim 19, which is distinctive in that the linear angles of inclination $\psi$ made by the generatrices of the lateral surface of the radiation output region with its inner surface are selected from the range from $(\pi/2 - \varphi - \sigma)$ to $(\pi/2 - \varphi + \sigma)$, where $\varphi$ is the angle made with the plane of the active layer by the normal to the front for radiation propagating within the radiation output region, and $\sigma$ is the angle of total internal reflection on the output surface for radiation propagating within the radiation output region.

**21.** An injection incoherent emitter as in Claim 19, which is distinctive in that the linear angles of inclination $\psi$ made by the generatrices of the lateral surface of the radiation output region with its inner surface are selected from the range from $(3\pi/4 - \varphi/2 - \sigma/2)$ to $(3\pi/4 - \varphi/2 + \sigma/2)$.

**22.** An injection incoherent emitter as in Claim 19, which is distinctive in that the linear angles of inclination $\psi$ made by the generatrices of the lateral surface of the radiation output region with its inner surface are selected from the range from $(\pi/4 - \varphi/2 - \sigma/2)$ to $(\pi/4 - \varphi/2 + \sigma/2)$.

**23.** An injection incoherent emitter as in any of Claims 1-18, which is distinctive in that the output region is formed as at least one right circular cylinder, one of whose bases is disposed on the cladding layer adjacent to it.

**24.** An injection incoherent emitter as in any of Claims 1-18, which is distinctive in that the output region is formed as at least one hexahedron, one of whose bases is disposed on the cladding layer adjacent to it.

**25.** An injection incoherent emitter as in Claim 24, which is distinctive in that the linear angle of inclination $\Psi$, made by at least one of the lateral planes of the hexahedron with the inner surface of the output region, is selected from the range from $(\pi/2 - \varphi - \Delta\varphi/2)$ to $(\pi/2 - \varphi + \Delta\varphi/2)$, where $\Delta\varphi$ is the angle of divergence for the radiation in the vertical plane.

**26.** An injection incoherent emitter as in Claim 24 or Claim 25, which is distinctive in that the linear angle of inclination $\psi$, made by at least one of the lateral planes of the hexahedron with the inner surface of the output region, is selected from the range from $(3\pi/4 - \varphi/2 - \Delta\varphi/2)$ to $(3\pi/4 - \varphi/2 + \Delta\varphi/2)$.

**27.** An injection incoherent emitter as in any of Claims 24-26, which is distinctive in that the linear angle of inclination $\psi$, made by at least one of the lateral planes of the hexahedron with the inner surface of the output region, is selected from the range from $(\pi/4 - \varphi/2 - \Delta\varphi/2)$ to $(\pi/4 - \varphi/2 + \Delta\varphi/2)$.

**28.** An injection incoherent emitter as in any of Claims 24-27, which is distinctive in that the linear angle of inclination ψ, made by at least one of the lateral planes of the hexahedron with the inner surface of the output region, is selected as equal to π/2.

29. An injection incoherent emitter as in any of Claims 23-28, which is distinctive in that the propagation angle (φ is selected to be less than the angle of total reflection σ.

30. An injection incoherent emitter as in any of Claims 19-29, which is distinctive in that antireflective coatings are applied on at least part of the introduced output surfaces.

31. An injection incoherent emitter as in any of Claims 19-30, which is distinctive in that reflective coatings are applied on part of the output surfaces.

32. An injection incoherent emitter as in any of Claims 1-31, which is distinctive in that in the heterostructure, at least two injection regions are formed with identical propagation angles φ.

33. An injection incoherent emitter as in Claim 33, which is distinctive in that an independent ohmic contact is made to each injection region on the outer side of the heterostructure.

34. An injection incoherent emitter as in Claim 32, which is distinctive in that for each injection region, an associated radiation output region is formed.

35. An injection incoherent emitter as in Claim 32 or Claim 33, which is distinctive in that one common radiation output region is formed at least for some of the injection regions.

36. An injection incoherent emitter as in any of Claims 32-35, which is distinctive in that injection regions of identical dimensions are disposed in an ordered manner in the heterostructure along a single line, as a linear sequence of injection regions.

37. An injection incoherent emitter as in Claim 35 or Claim 36, which is distinctive in that on the radiation output region side, at least on part of their outer surfaces, metallization layers are applied that are implemented in the form of strips that electrically connect the injection regions included in a linear sequence.

38. An injection incoherent emitter as in Claim 36 or Claim 37, which is distinctive in that at least two linear sequences of injection regions are formed in the heterostructure.

39. An injection incoherent emitter as in Claim 38, which is distinctive in that on the side where the injection regions are disposed, the metallization layers on their independent contacts are implemented as strips, each of which, in the operating device, electrically connects one injection region from each linear sequence of injection regions.

40. An injection incoherent emitter as in Claim 8, or 19, or 23, or 24, or 32, or any of Claims 36-39, which is distinctive in that the injection region is limited in size by means of introduced barrier layers, at least all the way to the active layer inclusive.

41. An injection incoherent emitter as in Claim 8, or any of Claims 11-15, or 19, or 22, or 24, or 32, or any of claims 36-40, which is distinctive in that, at least two adjacent injection regions are galvanically isolated all the way to the insulating second layer of the radiation output region, and ohmic contacts of the aforementioned injection regions are galvanically connected by the metallization layer.

**Amended Claims under Art. 19.1 PCT**

[received by the International Bureau on 26 April 2000 (26.04.00); the originally submitted Claims 1, 8, 19, 20, 23, and 24 have been amended; the remaining Claims remain unchanged (4 pages)]

**1.** An injection incoherent emitter, comprising a heterostructure containing an active layer, cladding layers, ohmic contacts, and at least on one side of the active layer, adjacent to the heterostructure, a radiation output region that is transparent to the radiation; said injection incoherent emitter being *distinctive* in that at least one radiation output region of appropriate configuration is made and said output region has at least one layer **characterized by** refractive index $n_{RORq}$, optical loss factor for the radiation $\alpha_{RORq}$ (cm$^{-1}$), thickness $d_{RORq}$ (µm), where $q$ = 1, 2,..., p are defined as integers that designate the sequential numbers labeling the layers of the output region, as counted from its boundary with the heterostructure; and the heterostructure with the adjoining radiation output region is **characterized by** an effective refractive index $n_{eff}$, where the effective refractive index $n_{eff}$ and the refractive index $n_{ROR1}$ are selected to satisfy the relations:

$0 < (\arccos(n_{eff}/n_{ROR1})) = \varphi \le \arccos(n_{eff\text{-}min}/n_{ROR1}) = \varphi_{max}$, and $n_{eff\text{-}min}$ is greater than $n_{min}$,
where $n_{eff\text{-}min}$ is the minimum value of $n_{eff}$ of all possible $n_{eff}$ for the multitude of heterostructures with radiation output regions that are of practical value,
$n_{min}$ is the smallest of the refractive indices in the cladding layers of the heterostructure,
$\varphi$ is the angle of propagation, made with the plane of the active layer by the normal to the front for radiation propagating within the radiation output region, and
$\varphi_{max}$ is the upper bound for possible propagation angles.

**2.** An injection incoherent emitter as in Claim 1, which is distinctive in that the active layer of the heterostructure is formed of at least one sublayer.

**3.** An injection incoherent emitter as in any of the Claims, which is distinctive in that the cladding layers, disposed respectively on the first and opposite second surfaces of the active layer, are formed of the cladding sublayers $I_i$ and $II_j$ respectively, where $i$ = 1, 2 ... $k$ and $j$ = 1, 2, ... $m$ are defined as integers that designate the sequential numbers labeling the cladding sublayers, as counted from the active layer, with refractive indices $n_{Ii}$ and $n_{IIj}$, respectively, and at least one cladding sublayer is made in each cladding layer.

**4.** An injection incoherent emitter as in Claim 3, which is distinctive in that at least one cladding sublayer of the heterostructure is implemented as a gradient layer.

**5.** An injection incoherent emitter as in any of the Claims, which is distinctive in that at least one injection region is made in the operating emitter.

**6.** An injection incoherent emitter as in any of the Claims, which is distinctive in that the thickness of the cladding layer adjacent to the radiation output region is selected to be less than the thickness of the cladding layer disposed on the opposite side of the active layer.

**7.** An injection incoherent emitter as in any of the Claims, which is distinctive in that the refractive index of the cladding sublayer adjacent to the radiation output region is selected to be greater than the refractive index of the outer cladding sublayer, disposed on the opposite side of the active layer.

**8.** An injection incoherent emitter as in any of the Claims, which is distinctive in that the dimensions and area $S_{IR}$ of the injection region are selected to be no greater than the dimensions and area $S_{in}$ of the surface of the radiation output region that is adjacent to the heterostructure and is called the inner surface.

**9.** An injection incoherent emitter as in any of the Claims, which is distinctive in that the thickness of the radiation output region $d_{RORq}$ is selected from the range 1 to 10,000 µm.

**10.** An injection incoherent emitter as in any of the Claims, which is distinctive in that the radiation output region is implemented as electrically conductive.

**11.** An injection incoherent emitter as in Claim 10, which is distinctive in that an ohmic contact is made to the outer surface of the radiation output region, opposite the inner surface.

**12.** An injection incoherent emitter as in any of the Claims, which is distinctive in that the radiation output region is made of optically homogeneous material.

**13.** An injection incoherent emitter as in any of the Claims, which is distinctive in that the radiation output region is made of at least two layers, and the first layer, bordering the heterostructure, is made electrically conductive, and the second layer is made from a material having an optical loss factor $\alpha_{ROR2}$ that is lower than the optical loss factor $\alpha_{ROR1}$ for the first layer.

**14.** An injection incoherent emitter as in Claim 13, which is distinctive in that the second layer is implemented as insulating.

**15.** An injection incoherent emitter as in Claim 13, which is distinctive in that the refractive index $n_{ROR2}$ of the second layer is selected to be lower than the refractive index $n_{ROR1}$ of the first layer, that borders the heterostructure.

**16.** An injection incoherent emitter as in any of the Claims, which is distinctive in that at least one layer of the radiation output region is made from a semiconductor.

**17.** An injection incoherent emitter as in any of the Claims, which is distinctive in that at least one layer of the radiation output region is made from introduced substrate.

**18.** An injection incoherent emitter as in any of the Claims, which is distinctive in that an ohmic contact is made to the first, electrically conductive layer of the radiation output region.

**19.** An injection incoherent emitter as in any of the Claims, which is distinctive in that the output region is made in the form of at least one truncated right circular cone, one of whose bases is disposed on the heterostructure.

**20.** An injection incoherent emitter as in Claim 19, which is distinctive in that the linear angles of inclination ψ made by the generatrices of the lateral surface of the radiation output region with its inner surface are selected from the range from $(\pi/2 - \varphi - \sigma)$ to $(\pi/2 - \varphi + \sigma)$, where σ is the angle of total internal reflection on the output surface for radiation propagating within the radiation output region.

**21.** An injection incoherent emitter as in Claim 19, which is distinctive in that the linear angles of inclination ψ made by the generatrices of the lateral surface of the radiation output region with its inner surface are selected from the range from $(3\pi/4 - \varphi/2 - \sigma/2)$ to $(3\pi/4 - \varphi/2 + \sigma/2)$.

**22.** An injection incoherent emitter as in Claim 19, which is distinctive in that the linear angles of inclination ψ made by the generatrices of the lateral surface of the radiation output region with its inner surface are selected from the range from $(\pi/4 - \varphi/2 - \sigma/2)$ to $(\pi/4 - \varphi/2 + \sigma/2)$.

**23.** An injection incoherent emitter as in any of Claims 1-18, which is distinctive in that the output region is formed as at least one right circular cylinder, one of whose bases is disposed on the heterostructure.

**24.** An injection incoherent emitter as in any of Claims 1-18, which is distinctive in that the output region is formed as at least one hexahedron, one of whose bases is disposed on heterostructure.

**25.** An injection incoherent emitter as in Claim 24, which is distinctive in that the linear angle of inclination ψ, made by at least one of the lateral planes of the hexahedron with the inner surface of the output region, is selected from the range from $(\pi/2 - \varphi - \Delta\varphi/2)$ to $(\pi 2 \varphi + \Delta\varphi/2)$, where Δφ is the angle of divergence for the radiation in the vertical plane.

**26.** An injection incoherent emitter as in Claim 24 or Claim 25, which is distinctive in that the linear angle of inclination ψ, made by at least one of the lateral planes of the hexahedron with the inner surface of the of output region, is selected from the range from $(3\pi/4 - \varphi/2 - \Delta\varphi/2)$ to $(3\pi/4 - \varphi/2 + \Delta\varphi/2)$.

**27.** An injection incoherent emitter as in any of Claims 24-26, which is distinctive in that the linear angle of inclination ψ, made by at least one of the lateral planes of the hexahedron with the inner surface of the output region, is selected from the range from $(\pi/4 - \varphi/2 - \Delta\varphi/2)$ to $(\pi/4 - \varphi/2 + \Delta\varphi/2)$.

**28.** An injection incoherent emitter as in any of Claims 24-27, which is distinctive in that the linear angle of inclination ψ, made by at least one of the lateral planes of the hexahedron with the inner surface of the output region, is selected as equal to $\pi/2$.

**29.** An injection incoherent emitter as in any of Claims 23-28, which is distinctive in that the propagation angle (φ is selected to be less than the angle of total reflection σ.

**30.** An injection incoherent emitter as in any of Claims 19-29, which is distinctive in that antireflective coatings are applied on at least part of the introduced output surfaces.

**31.** An injection incoherent emitter as in any of Claims 19-30, which is distinctive in that reflective coatings are applied on part of the output surfaces.

**32.** An injection incoherent emitter as in any of Claims 1-31, which is distinctive in that in the heterostructure, at least two injection regions are formed with identical propagation angles $\varphi$.

**33.** An injection incoherent emitter as in Claim 33, which is distinctive in that an independent ohmic contact is made to each injection region on the outer side of the heterostructure.


**Statement under Article 19(1) PCT**

In the proposed new revision of the Claims, we have amended Claims 1, 8, 19, 20, 23, and 24 (the numbers of the Claims are unchanged).
For consistent terminology:

- in Claim 1 (p. 25, lines 7 and 8) and in Claim 8 (p. 26, line 16), instead of the words "...to the corresponding cladding layer...", we write "...the heterostructure..." based on Claim 1 (p. 25, lines 14 and 15), Claims 13 and 15; p. 8, paragraphs 1 and 3, p. 15, paragraph 6, p. 19, paragraph 4 of the description;
- in Claims 19, 23, and 24, instead of the words "...the cladding sublayer adjacent to it...", we write "...the heterostructure...".

Further, based on the mathematical formula (1) in the text of the description on p. 3 and the mathematical formulas (2), (3) on p. 4, we have amended the mathematical formula in Claim 1 (p. 25, lines 21-23), namely
$0 < (\arccos(n_{eff}/n_{ROR1})) = \varphi \leq \arccos(n_{eff\text{-}min}/n_{ROR1}) = \varphi_{max}$, and $n_{eff\text{-}min}$ is greater than $n_{min}$,
In connection with the amendment of the mathematical formula, at the end of Claim 1:

- we have transferred the definition given for the angle ($\varphi$ in Claim 20, called the angle of propagation based on the description, p. 4, paragraph 1, i.e., we have inserted the words "$\varphi$ is the angle of propagation, made with the plane of the active layer by the normal to the front for radiation propagating within the radiation output region.";
- based on p. 4, paragraph 2, we have inserted the words "$\varphi_{max}$ is the upper bound for possible propagation angles."

Because of the amendment of Claim -1, we have eliminated the words "$\varphi$ is the angle made with the plane of the active layer by the normal to the front for radiation propagating within the radiation output region..." from Claim 20.
The changes made do not go beyond the disclosure of the invention in the original documents of the application, and do not require additional disclosure of the invention with amendment of the text of the description in the application. No changes are required in the drawings of the original documents.

FIG.1

FIG.2

FIG.3

FIG.4

FIG.5

FIG.9

FIG.10

FIG.12

FIG.13

FIG.7

FIG.8

FIG.6

FIG.11

FIG.14

FIG.15

FIG.16

FIG.17

FIG.18

FIG.19

FIG.20

# EP 1 158 585 A1

<table>
<tr><td colspan="2" style="text-align:center">INTERNATIONAL SEARCH REPORT</td><td>International application No.<br>PCT/RU 99/00245</td></tr>
</table>

**A. CLASSIFICATION OF SUBJECT MATTER**

IPC 7: H01L 33/00

According to International Patent Classification (IPC) or to both national classification and IPC

**B. FIELDS SEARCHED**

Minimum documentation searched (classification system followed by classification symbols)

IPC 7: H01L 33/00

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | EP 0727827 A2 (MITSUBISHI CABLE INDUSTRIES,LTD) 21 August 1996 (21.08.96), the abstract | 1-41 |
| A | SU 1455373 A1 (INSTITUT RADIOTEKHNIKI I ELEKTRONIKI AN SSSR) 30 January 1989 (30.01.89) | 1-41 |
| A | EP 0849812 A2 (SIMENS AKTIENGESELLSCHAFT) 24 June 1998 (24.06.98), the abstract | 1-41 |
| A | WO 85/03809 A1 (CODENOLL TECHNOLOGY CORPORATION) 29 August 1985 (29.08.85), the abstract | 1-41 |

☐ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 05 October 1999 (05.10.99) | 14 October 1999 (14.10.99) |

| Name and mailing address of the ISA/<br><br>RU<br>Facsimile No. | Authorized officer<br><br><br>Telephone No. |
|---|---|

Form PCT/ISA/210 (second sheet) (July 1992)